(19) Europäisches Patentamt
European Patent Office
Office européen des brevets

(11) **EP 3 788 443 B1**

(12) **EUROPÄISCHE PATENTSCHRIFT**

(45) Veröffentlichungstag und Bekanntmachung des Hinweises auf die Patenterteilung:
**15.06.2022 Patentblatt 2022/24**

(21) Anmeldenummer: **18724506.3**

(22) Anmeldetag: **04.05.2018**

(51) Internationale Patentklassifikation (IPC):
***G03F 7/00*** *(2006.01)*

(52) Gemeinsame Patentklassifikation (CPC):
**G03F 7/0002**

(86) Internationale Anmeldenummer:
**PCT/EP2018/061584**

(87) Internationale Veröffentlichungsnummer:
**WO 2019/210976 (07.11.2019 Gazette 2019/45)**

(54) **STEMPEL UND VERFAHREN ZUM PRÄGEN**

STAMP AND METHOD FOR EMBOSSING

POINÇON ET PROCÉDÉ D'ESTAMPAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**10.03.2021 Patentblatt 2021/10**

(73) Patentinhaber: **EV Group E. Thallner GmbH**
**4782 St. Florian am Inn (AT)**

(72) Erfinder:
• **WIMPLINGER, Markus**
  **4910 Ried im Innkreis (AT)**
• **MITTENDORFER, Gerald**
  **4975 Suben (AT)**

(74) Vertreter: **Schneider, Sascha et al**
**Becker & Müller**
**Patentanwälte**
**Turmstraße 22**
**40878 Ratingen (DE)**

(56) Entgegenhaltungen:
| | |
|---|---|
| EP-A2- 2 942 667 | WO-A1-2015/078520 |
| CN-A- 102 275 445 | US-A1- 2003 234 470 |
| US-A1- 2004 036 201 | US-A1- 2017 176 853 |

EP 3 788 443 B1

**Beschreibung**

Die Erfindung betrifft einen Stempel, eine Verwendung eines Stempels, eine Vorrichtung mit einem Stempel und ein Verfahren zum Prägen gemäß den nebengeordneten Ansprüchen.

Im Stand der Technik existieren zwei grundlegende Arten von Aushärtemechanismen für eine Prägemasse, welches durch eines der unzähligen Prägeverfahren geformt werden kann. Einerseits kann man die Prägemasse thermisch, andererseits mittels elektromagnetischer Strahlung aushärten. Daneben gibt es im Stand der Technik thermische Prägeverfahren ("Heißprägen", engl. "Hot Embossing"), bei denen in thermoplastische Materialien geprägt wird. Insbesondere die thermische Aushärtung oder thermische Prägeverfahren erfolgen mittels Vorrichtungen, die über sehr komplexe, große Heizsysteme verfügen, welche die notwendige Wärme aufbringen können. Diese Heizsysteme befinden sich über und/oder unter dem Stempel bzw. dem Substrat, auf dem sich die zu prägende Prägemasse befindet.

Ein großes Problem im Stand der Technik ist die konstruktive Gestaltung der Heizsysteme. Die meisten Heizsysteme sind groß, klobig, schwerfällig, teuer und produzieren die Wärme nicht in der Nähe der auszuhärtenden Prägemasse bzw. der zu prägenden Prägemasse. Die erzeugte Wärme muss über den gesamten Stempel und/oder durch den Probenhalter und das Substrat zur Prägemasse transportiert werden. Insbesondere geht ein effizienter Wärmekontakt zwischen dem Heizsystem und dem Träger, auf dem der Weichstempel fixiert wird, verloren, wenn der Träger und der Weichstempel gebogen werden und die Heizung von der Stempelseite aus erfolgt. Der Wärmestrom vom Heizsystem in Richtung der auszuhärtenden Prägemasse muss dann, sofern das Heizsystem selbst nicht krümmbar konstruiert wurde, den thermischen Widerstand zwischen der Rückseite des Trägers und seiner Heizfläche überbrücken.

Stempel, die ein Heizelement aufweisen, sind Stand der Technik. Die Druckschriften US2017/176853 A1, EP2942667 A2, CN102275445 A, US2003/234470 A1 und US 2004/036201 A1 offenbaren einen Stempel, der einen Weichstempel und einen am Weichstempel fixierten Träger aufweist. Beim Stempel gemäß EP2942667 A2, CN102275445 A, US2003/234470 A1 oder US 2004/036201 A1 weist der Träger ein Heizelement auf. In der Druckschrift US2017/176853 A1 hingegen weist der Weichstempel, nicht der Träger, ein Heizelement auf. Insbesondere ist bei einer Ausführungsform der Druckschrift EP2942667 A2 der Träger lösbar fixiert. Des weiteren offenbart die Druckschrift WO2015/078520

A1 einen Stempel, der einen Weichstempel und einen am Weichstempel fixierten biegbaren Träger aufweist, wobei der Stempel leitfähige Nanopartikel aufweist, um eine direkte Erwärmung des Stempels zu erzielen.

Es ist daher die Aufgabe der vorliegenden Erfindung, die Nachteile des Stands der Technik zu beseitigen.

Diese Aufgabe wird mit dem Gegenstand der nebengeordneten Ansprüche gelöst. Vorteilhafte Weiterbildungen der Erfindung sind in den Unteransprüchen angegeben.

Erfindungsgemäß vorgesehen ist ein Stempel, aufweisend einen

Weichstempel und einen am Weichstempel fixierten biegbaren Träger, wobei der Träger mindestens ein Heizelement aufweist und lösbar am Weichstempel fixiert ist. Vorzugsweise werden Träger und Weichstempel ausschließlich über Adhäsionskräfte miteinander fixiert, insbesondere indem der Weichstempel auf den Träger aufgeprägt wird. Denkbar, wenn auch ist auch, dass ein Weichstempel geformt und über Fixierelemente, die sich am Träger befinden, mit dem Träger fixiert wird.

Erfindungsgemäß weiterhin vorgesehen ist eine Vorrichtung, aufweisend einen erfindungsgemäßen Stempel sowie eine Steuerungseinheit, insbesondere eine Strom- und/oder Spannungsquelle, zur Steuerung des mindestens einen Heizelements.

Erfindungsgemäß weiterhin vorgesehen ist eine Verwendung eines erfindungsgemäßen Stempels zum Prägen einer Prägemasse.

Erfindungsgemäß weiterhin vorgesehen ist ein Verfahren zum Prägen einer Prägemasse mit einem erfindungsgemäßen Stempel mit den folgenden Schritten, insbesondere dem folgenden Ablauf:

- Beschichten eines Substrats mit der Prägemasse,
- Ausrichten des Stempels relativ zum Substrat,
- Prägen der Prägemasse durch den Stempel,
- Erwärmung der Prägemasse durch das mindestens eine Heizelement des Trägers,
- Entformung des Stempels von der Prägemasse.

Der Erfindung liegt insbesondere der Gedanke zugrunde, den Stempel für die Heißprägung aus zwei Bauteilen mit technisch stark unterschiedlichen Eigenschaften zu konstruieren. Der Stempel besteht aus einem Träger, der direkt heizbar ist, und einem Strukturteil (der Weichstempel), welches aus einem weichen, verformbaren Material besteht. Der Träger wird derart konstruiert, dass er direkt heizbar ist, d.h. die Heizelemente direkt in der Festkörperstruktur des Trägers konstruiert werden. Der Träger wird somit nicht nur als mechanisches Konstruktionselement, sondern auch als Heizer, insbesondere als Dünnschichtheizer, verwendet.

Das charakteristische Unterscheidungsmerkmal zwischen dem erfindungsgemäßen Stempel und Bauteilen des Stands der Technik, mit denen ein entsprechender Weichstempel auch kontaktieren könnte, ist, dass der erfindungsgemäße Stempel und damit auch der Träger verformbar sind und einen entsprechend geringen Biegewiderstand besitzen. Des Weiteren weist der Träger neben seinem geringen Biegewiderstand das mindestens eine Heizelement auf.

Der Kern der Erfindung besteht insbesondere darin, einen Stempel vorzusehen, bei dem die Heizung über festkörperphysikalische Vorgänge, insbesondere über die Erzeugung Joulescher Wärme, direkt im Träger des Stempels erzeugt wird. Insbesondere handelt es sich dabei um einen Dünnschichtheizer. Der Heizer wird insbesondere so konstruiert, dass er in einem wenige Millimeter dünnen Träger Platz hat.

Die notwendige Wärme zur Aushärtung der Prägemasse wird vorteilhaft so nahe wie möglich an der Prägemasse erzeugt. Damit fällt ein Wärmetransport über eine längere Strecke aus bzw. Wärmeverluste werden weitestgehend minimiert. Der gesamte Stempel wird um einiges kompakter und kostengünstiger.

Der erfindungsgemäße Stempel weist einen Weichstempel und einen am Weichstempel fixierten biegbaren Träger auf, wobei der Träger mindestens ein Heizelement aufweist und lösbar am Weichstempel fixiert ist.

Unter einem Träger, insbesondere einer Rückplatte (engl.: back-plane), versteht man ein stabilisierendes Element, insbesondere ein Konstruktionselement, für den Weichstempel. Bei dem Träger kann es sich insbesondere um eine Platte oder eine Folie handeln. Der Träger verfügt über mindestens einen, aktiven und/oder passiven, Heizer.

Unter einem Weichstempel versteht man das Prägeelement, welches über die Strukturen verfügt, mit deren Hilfe die Prägemasse geprägt wird. Der Weichstempel wird, insbesondere reversibel, also lösbar, am Träger fixiert.

Weichstempelmaterialien zur Herstellung vom Weichstempel können insbesondere UV-härtbare Materialien oder thermisch härtbare Materialien sein. Allgemeiner kann die Aushärtung durch elektromagnetische Strahlung, durch Wärme, durch Strom, durch magnetische Felder und/oder andere Verfahren durchgeführt werden. Weichstempel werden beispielsweise als Negativ eines Masterstempels abgeformt.

Der E-Modul des Weichstempelmaterials ist dabei kleiner als 1000 GPa, vorzugsweise kleiner als 500 GPa, noch bevorzugter kleiner als 200 GPa, am bevorzugtesten kleiner als 100 GPa, am allerbevorzugtesten kleiner als 20 GPa.

Unter einem Stempel versteht man die Kombination aus einem Träger und einem Weichstempel.

Insbesondere die weichen Strukturen des Weichstempels zusammen mit der Biegbarkeit des Trägers mit seinem geringen Biegewiderstand und das mindestens eine Heizelement ermöglichen ein verlässlicheres Entformen im Vergleich zum Stand der Technik.

Unter der Prägemasse (im Folgenden auch Prägematerial genannt) versteht man ein Polymer, welches durch den Stempel, insbesondere den Weichstempel, geprägt und damit strukturiert wird.

Das Prägematerial kann insbesondere thermisch aushärtendes Material, thermisch formbares Material, insbesondere thermoplastisches Material und/oder ein Hybridmaterial sein, das durch eine Kombination von thermischen Prozessen und Bestrahlung mit elektromagnetischer Strahlung formbar ist.

Eine bevorzugte Ausführungsform für ein derartiges Hybridmaterial ist ein Material, welches vor Bestrahlung mit UV Licht thermoplastische Eigenschaften hat, und anschließend durch Bestrahlung mit UV Licht aushärtet. Mit Vorzug kann der Aushärteprozess durch gleichzeitiges Heizen beschleunigt werden.

Unter einem Substrat versteht man ein Objekt, auf dem eine Prägemasse abgeschieden wird, die durch den erfindungsgemäßen Stempel geprägt werden soll.

Andere bevorzugte Ausführungsformen: Bevorzugt ist vorgesehen, dass

- der Stempel einen temperierbaren Trägerhalter aufweist, und/oder
- das mindestens eine Heizelement als, insbesondere mäanderförmige, Leiterbahn ausgebildet ist, insbesondere als metallischer und/oder n-dotierter Bereich, und/oder
- das mindestens eine Heizelement als Spule, insbesondere Flachspule, ausgebildet ist, und/oder
- der Weichstempel leitfähige Nanopartikel aufweist, und/oder
- das mindestens eine Heizelement als leitfähige Schicht im und/oder auf dem Träger ausgebildet ist, bevorzugt besteht der Träger zumindest teilweise, vorzugsweise vollständig, aus einem leitfähigen Material, insbesondere Metall, und/oder
- im Träger eine Stromdichte zwischen 0.01 A/m$^2$ und 1 MA/m2 erzeugbar ist, vorzugsweise zwischen 0.1 A/m2 und 1 MA/m2, bevorzugter zwischen 1 A/m2 und 1 MA/m2, noch bevorzugter zwischen 10 A/m2 und 1 MA/m2, am bevorzugtesten zwischen 100 A/m2 und 1 MA/m2, am allerbevorzugtesten zwischen 1000 A/m2 und 1 MA/m2, und/oder
- der Träger als Platte ausgebildet ist, wobei die Dicke der Platte zwischen 0.01 mm und 20 mm beträgt, vorzugsweise zwischen 0.05 mm und 15 mm, bevorzugter zwischen 0.1 mm und 10 mm, noch bevorzugter zwischen 0.5 mm und 5 mm, am bevorzugtesten zwischen 0.75mm und 2.5 mm, am allerbevorzugtesten zwischen 1 mm und 2 mm, und/oder
- der Träger als Folie ausgebildet ist, insbesondere als Folie bestehend aus einem organischen Halbleiter, wobei die Dicke der Folie zwischen 0.01 mm und 5 mm beträgt, vorzugsweise zwischen 0.05 mm und 2.5 mm, bevorzugter zwischen 0.1 mm und 2 mm, noch bevorzugter zwischen 0.5 mm und 1.5 mm, am bevorzugtesten zwischen 0.7 5mm und 1.25 mm, am allerbevorzugtesten zwischen 1 mm und 1.25 mm.

Der erfindungsgemäße Stempel weist mindestens einen Träger und einen Weichstempel auf.

Vorzugsweise verfügt die Vorrichtung auch noch über einen Substrathalter, welcher das Substrat, auf dem die Prägemasse abgeschieden wird, fixiert.

Vorzugsweise verfügt die Vorrichtung auch noch über einen Trägerhalter, der temperiert, insbesondere gekühlt, werden kann. Der Trägerhalter ist ein wichtiges Teil der Vorrichtung, dessen Aufgabe insbesondere darin besteht, den erfindungsgemäßen Stempel zu halten und/oder zu verformen und/oder nach dem Heizvorgang durch das mindestens eine Heizelement des Trägers auch wieder schnell und effizient zu kühlen. Der Trägerhalter ist dabei insbesondere so konstruiert, dass die Wärmeleitfähigkeit maximal, bzw. der thermische Widerstand minimal wird. Im weiteren Verlauf der Offenbarung werden konstruktionstechnische Merkmale angegeben, mit deren Hilfe die effiziente Temperierung, insbesondere Kühlung, des Stempels über den Trägerhalter bewerkstelligt werden kann.

Mit Vorteil ermöglicht der erfindungsgemäße Stempel, insbesondere in Kombination mit dem Trägerhalter aufgrund des kompakten Aufbaus und der damit verbundenen reduzierten thermischen Masse und dem kürzeren Weg für die Wärmeleitung, wesentlich schnellere Heiz- und Kühlrampen als Lösungen aus dem Stand der Technik. Somit werden ein wesentlich höherer Durchsatz und dadurch eine wesentliche Reduktion der Produktionskosten erreicht.

Mit Vorzug ist die mögliche Heizrate >40°C/min, weiter vorzugsweise >100°C/ min, bevorzugter >20°C/ s, noch bevorzugter >50°C/ s, am bevorzugtesten >100°C/ s.

Die Kühlrate erreicht insbesondere >20°C/min, vorzugsweise >40°C/ min, bevorzugter >100°C/ min, noch bevorzugter >40°C/ s.

Alle erfindungsgemäßen Ausführungsformen des Heizers, die im Träger eingebaut werden können, können auch im Substrathalter und/oder im Trägerhalter verbaut werden. Dies ist vor allem dann von Interesse und Vorteil, wenn eine symmetrische Heizung der Prägemasse, d.h. von der Ober- und der Unterseite erfolgen soll. Im weiteren Verlauf werden der besseren Übersicht halber alle Ausführungsformen des Heizers nur im Zusammenhang mit dem Träger beschrieben. Alle Merkmale gelten aber auch für den Heizer im Zusammenhang mit dem Substrathalter und/oder dem Trägerhalter.

Der Träger kann insbesondere aus mindestens einem der folgenden Materialien gefertigt werden.

- Metall, insbesondere
  ○ Cu, Ag, Au, Al, Fe, Ni, Co, Pt, W, Cr, Pb, Ti, Ta, Zn, Sn

- Halbleiter, insbesondere
  ○ Ge, Si, Alpha-Sn, Fullerene, B, Se, Te

- Verbindungshalbleiter, insbesondere
  ○ GaAs, GaN, InP, InxGa1-xN ,InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe

- Polymer, insbesondere
  ○ Acrylester-Styrol-Acrylnitril, Acrylnitril/ Methylmethacrylat, Acrylnitril/Butadien/Acrylat, Acrylnitril/chloriertes Polyethylen/Styrol, Acrylnitril-Butadien-Styrol, Acrylpolymere, Alkydharze, Butadien-Kautschuk, Butylkautschuk, Casein-Kunststoffe, Kunsthorn, Celluloseacetat, Celluloseether und Derivate, Cellulosehydrat, Cellulosenitrat, Chitin, Chitosan, Chloropren-Kautschuk, Cyclo-Olefin-Copolymere, Einheitliches Polyvinylchlorid, Epoxidharz, Ethylen-EthylacrylatCopolymer, Ethylen-Polyvinylacetat, Ethylen-Propylen-Copolymer, Ethylen-Propylen-DienKautschuk, Ethylenvinylacetat, Expandierbares Polystyrol, Fluorkautschuk, Harnstoff-Formaldehydharz, Harnstoffharze, Isopren-Kautschuk, Lignin, MelaminFormaldehydharz, Melaminharze, Methylacrylat/Butadien/ Styrol, Naturkautschuk, Perfluoralkoxylalkan, Phenol-Formaldehydharz, Polyacetale, Polyacrylnitril, Polyamid, Polybutylensuccinat, Polybutylenterephthalat, Polycaprolacton, Polycarbonat, Polycarbonate, Polychlortrifluorethylen, Polyester, Polyesteramid, Polyetheralkohole, Polyether-Block-Amid, Polyetherimid, Polyetherketone, Polyethersulfon, Polyethylen, Polyethylenterephthalat, Polyhydroxyalkanoate, Polyhydroxybutyrat, Polyimid, Polyisobutylen, Polylactid (Polymilchsäure), Polymethacrylmethylimid, Polymethylmethacrylat, Polymethylpenten, Polyoxymethylen oder Polyacetal, Polyphenylenether, Polyphenylensulfid, Polyphthalamid, Polypropylen, Polypropylen-Copolymere, Polypyrrol, Polystyrol, Polysulfon, Polytetrafluorethylen, Polytrimethylenterephthalat, Polyurethan, Polyvinylacetat, Polyvinylbutyral, Polyvinylchlorid (Hart-PVC), Polyvinylchlorid (Weich-PVC), Polyvinylidenfluorid, Polyvinylpyrrolidon, Styrol-AcrylnitrilCopolymerisat, Styrol-Butadien-Kautschuk, Styrol-Butadien-Styrol, Synthetischer Kautschuk, Thermoplastisches Polyurethan, Ungesättigter Polyester, Vinylacetat-Copolymere, Vinylchlorid/ Ethylen/ Methacrylat, Vinylchlorid/Ethylen, Vinylchlorid-Vinylacetat-Copolymere, Weichgemachtes Polyvinylchlorid

- Metallische Gläser

- Nichtmetallische Gläser, insbesondere

  ○ Organische nichtmetallische Gläser

  ○ Anorganische nichtmetallische Gläser, insbesondere

    ▪ Nichtoxidische Gläser, insbesondere

- Halogenidgläser

- Chalkogenidgläser

▪ Oxidische Gläser, insbesondere

- Phosphatische Gläser

- Silikatische Gläser, insbesondere

  ◦ Alumosilikatgläser

  ◦ Bleisilikatgläser

  ◦ Alkali-Silikatgläser, insbesondere
  ▪ Alkali-Erdalkalisilikatgläser

  ◦ Borosilikatgläser

  ◦ Quarzglas

  ▪ Boratgläser, insbesondere
  ◦ Alkaliboratgläser

• Materialien, die als Gläser bezeichnet werden aber keine sind
◦ Saphirglas.

In einer bevorzugten erfindungsgemäßen Ausführungsform weist der Träger ein Halbleiter- und/oder Verbindungshalbleitermaterial auf und weist bevorzugt mindestens einen leitfähigen Bereich auf.

Insbesondere können sich im Träger neben dem mindestens einen Heizelement auch noch andere funktionelle Einheiten, insbesondere Sensoren, vorzugsweise Temperatursensoren, Speicher und/oder Mikrochips befinden. Durch die Verwendung von Heizelementen, Sensoren und/oder Mikrochips kann im Träger insbesondere eine ganze Steuerungsvorrichtung für eine Regelschleife hergestellt werden.

In dieser bevorzugten erfindungsgemäßen Ausführungsform kann durch mehrere Prozessschritte mindestens ein leitfähiger Bereich, durch welcher Strom fließen kann, direkt im Träger erzeugt werden. In einem ersten Prozessschritt bringt man hierzu einen, insbesondere photosensitiven, Lack auf dem Träger auf. In einem zweiten Prozessschritt strukturiert man den Lack, insbesondere durch Imprint und/oder photolithographische Prozesse. In einem dritten Prozessschritt wird der Lack entwickelt. In einem weiteren Prozessschritt dient der so erzeugte Lack als Dotierungsmaske während eines Dotierprozess, in dem das Halbleitermaterial an den für die Dotierelemente zugänglichen Bereichen dotiert wird. In einem weiteren Prozessschritt wird der Lack entfernt. Durch diesen beispielhaften Prozess kann ein Halbleiterträger mit mindestens einem leitfähigen Bereich geschaffen werden.

In einer speziellen, bevorzugten erfindungsgemäßen Ausführungsform weist der Träger ein Dielektrikum auf und weist mindestens einen leitfähigen, insbesondere metallischen, Bereich auf.

Insbesondere besteht der Träger aus einem Dielektrikum, in dem durch mehrere unterschiedliche Prozesse mindestens ein leitfähiger, insbesondere metallischer, Bereich eingebracht wird. In einem ersten Prozessschritt bringt man einen, insbesondere photosensitiven, Lack auf den dielektrischen Träger auf. In einem zweiten Prozessschritt strukturiert man den Lack, insbesondere durch Imprint und/oder photolithographische Prozesse. In einem dritten Prozessschritt wird der Lack entwickelt. In einem weiteren Prozessschritt dient der so erzeugte Lack als Ätzmaske während eines Ätzprozesses, in dem das dielektrische Material an den für die Ätzsubstanz zugänglichen Bereichen geätzt wird. In einem weiteren Prozessschritt wird der Lack entfernt. In einem weiteren Prozessschritt wird ein elektrisches Material auf den Träger aufgebracht und füllt insbesondere die geätzten Bereiche auf. In einem weiteren Prozessschritt wird die Beschichtungsseite des Trägers so lange gedünnt, bis das gesamte Metall von der Oberseite entfernt wurde und nur mehr die geätzten Bereiche im dielektrischen Träger ausfüllt. Durch diesen beispielhaften Prozess kann ein dielektrischer Träger mit leitfähigen Bereichen geschaffen werden.

Der mindestens eine leitfähige Bereich wird insbesondere verwendet, um Strukturen zu erzeugen, mit deren Hilfe man Wärme generiert. Insbesondere wird Joulesche Wärme erzeugt, d.h. Verlustleistungswärme.

In einer anderen bevorzugten Ausführungsform weist der Träger mindestens eine Spule, insbesondere Flachspule, auf. Hierzu können Flachspulen im Träger erzeugt werden. Die Flachspulen können, sofern sie von einem hochfrequenten Wechselstrom durchflossen werden, in benachbarten, leitfähigen Regionen, insbesondere durch Induktion, Wärme erzeugen.

In einer anderen bevorzugten Ausführungsform weist der Weichstempel leitfähige Nanopartikel auf. Insbesondere befinden sich leitfähige Nanopartikel im Weichstempel, sodass ein hochfrequentes magnetisches Wechselfeld, welches im Träger erzeugt wird, die Nanopartikel im Weichstempel erwärmt.

Bevorzugt besteht der Träger aus leitfähigen Bereichen, die als Spulen, insbesondere Flachspulen, ausgeführt werden. Die Spulen werden vorzugsweise von einem Wechselstrom durchflossen und erzeugen damit ein sich zeitlich änderndes Magnetfeld. Die Spulen sind vorzugsweise direkt miteinander verbunden und verteilen sich vorzugsweise gleichmäßig über den Träger, sodass eine möglichst hohe Anzahl von Magnetfeldquellen vorhanden ist. Vorteilhaft soll ein möglichst homogenes Magnetfeld durch eine hohe Anzahl von Spulen erzeugt werden.

In einer anderen bevorzugten Ausführungsform besteht der Träger zumindest teilweise, vorzugsweise vollständig aus einem leitfähigen Material, insbesondere Metall. Die Erwärmung wird durch eine hohe Stromdichte erzeugt, welche in dem metallischen Träger erzeugt wird. Die Stromdichte ist umso größer, je kleiner die Querschnittsfläche des Trägers ist. Die Länge und Breite des Trägers sind durch die Größe des Weichstempels bestimmt und vorgegeben. Die Dicke des Trägers kann meistens frei gewählt werden, solange die notwendige mechanische Stabilität des Trägers aufrechterhalten wird. Die Dicke des Trägers ist daher vorzugsweise minimal.

Die Stromdichte beträgt, insbesondere für ein Drei-Sigma Konfidenzniveau von 98%, zwischen 0.01 A/m2 und 1 MA/m2, vorzugsweise zwischen 0.1 A/m2 und 1 MA/m2, bevorzugter zwischen 1 A/m2 und 1 MA/m2, noch bevorzugter zwischen 10 A/m2 und 1 MA/m2, am bevorzugtesten zwischen 100 A/m2 und 1 MA/m2, am allerbevorzugteste zwischen 1000 A/m2 und 1 MA/m2.

In einer anderen bevorzugten Ausführungsform handelt es sich bei dem Träger um eine Platte.

Die Dicke der Platte beträgt, insbesondere für ein Drei-Sigma Konfidenzniveau von 98%, zwischen 0.01 mm und 20 mm, vorzugsweise zwischen 0.05 mm und 15 mm, bevorzugter zwischen 0.1 mm und 10 mm, noch bevorzugter zwischen 0.5 mm und 5 mm, am bevorzugtesten zwischen 0.5 mm und 2.5 mm, am allerbevorzugtesten zwischen 0.5 mm und 2 mm.

In einer anderen bevorzugten Ausführungsform handelt es sich bei dem Träger um eine Folie, insbesondere um eine Folie bestehend aus einem organischen Halbleiter.

Die Dicke der Folie beträgt, insbesondere für ein Drei-Sigma Konfidenzniveau von 98%, zwischen 0.01 mm und 5 mm, vorzugsweise zwischen 0.05 mm und 2.5 mm, bevorzugter zwischen 0.1 mm und 2 mm, noch bevorzugter zwischen 0.5 mm und 1.5 mm, am bevorzugtesten zwischen 0.5 mm und 1.25 mm, am allerbevorzugteste zwischen 0.5 mm und 1.25 mm.

In einer anderen bevorzugten Ausführungsform ist der Stempel Teil einer Vorrichtung, die so konzipiert ist, dass die Richtung des vom Träger erzeugten Wärmeflusses gezielt gesteuert werden kann. Die Vorrichtung leitet während der Aushärtung der Prägemasse die Wärme des Trägers vorzugsweise ausschließlich in Richtung der auszuhärtenden Prägemasse. Nach erfolgter Aushärtung der Prägemasse wird die Kühlung des Stempels, insbesondere des Trägers, und/oder der Prägemasse durch eine Umleitung des Wärmeflusses in die der Prägemasse entgegenliegenden Seite unterstützt. Diese Umleitung wird durch eine Veränderung des thermischen Widerstandes R bewerkstelligt. Der thermische Widerstand R ist der Quotient aus der Temperaturdifferenz ΔT (delta T) und dem Wärmestrom dQ/dt, d.h.

$$R_{th} = \frac{\Delta T}{\dot{Q}} = \frac{T_A - T_I}{\frac{\partial Q}{\partial t}}$$

Der thermische Widerstand R ist daher kein reiner Materialparameter sondern hängt von Umgebungsparametern, insbesondere der äußeren Temperatur $T_A$ ab. Durch ein entsprechendes Kühlsystem kann der thermische Widerstand R daher sehr einfach beeinflusst werden.

Der thermische Widerstand kann auch durch reine Material und Geometrieparameter definiert werden.

$$R_{th} = \frac{l}{\lambda A}$$

Hierbei sind l und A die Dicke bzw. der Querschnitt des von Wärme durchströmten (homogenen) Körpers, insbesondere Trägerhalters, und λ ist dessen thermische Leitfähigkeit. Durch eine relative geringe Dicke des Trägerhalters kann so der Wärmewiderstand konstruktionstechnisch sehr leicht verkleinert werden.

Die Vorrichtung besitzt insbesondere an der Rückseite des Stempels Vorrichtungen zur Temperierung, insbesondere Kühlung, des Stempels. In einer besonderen bevorzugten Ausführungsform kontaktiert der Träger einen kühlbaren Trägerhalter. Der Trägerhalter verfügt insbesondere über Kühlelemente, insbesondere Kühlrippen. Denkbar wären auch Peltierelemente oder Vertiefungen, insbesondere Schläuche oder Rohrleitungen, durch die ein Kühlfluid gepumpt wird. Wichtig ist, dass eine Wärmemenge, die vom Trägerhalter aufgenommen wird, durch konstruktionstechnische Maßnahmen so effizient wie möglich, abgeführt wird. Bevorzugt erfolgt die Abfuhr mit Kühlfluiden.

In der Vorrichtung können Stempel, insbesondere Weichstempel und Träger, und/oder der Substrathalter und/oder das Substrat auch transparent für elektromagnetische Strahlung sein, um die Verwendung von thermischer Aushärtung und elektromagnetischer Aushärtung zu kombinieren.

Die elektromagnetische Strahlung besitzt dann vorzugsweise eine Wellenlänge im Bereich zwischen 10nm und 2000nm, mit Vorzug zwischen 50nm und 1500nm, mit größerem Vorzug zwischen 100nm und 1000nm, mit allergrößtem Vorzug zwischen 150nm und 500nm, mit allergrößtem Vorzug zwischen 200nm und 370nm.

Ein weiterer erfindungsgemäßer Aspekt der Erfindung besteht darin, dass der Weichstempel von dem Träger entfernt werden kann, um den Träger mit einem neuen, frischen, weniger verbrauchten und weniger schadhaften, neuen Weichstempel zu bestücken. Der Weichstempel kann nach mehreren Prägevorgängen so abgenutzt sein, dass ein Austausch zwingend erforderlich wird. Insbesondere wird der Träger vor der neuen Bestückung mit einem Weichstempel gereinigt. Dadurch wird es möglich, den relativ teuer herzustellenden Träger mehrmals zu verwenden.

Das Entfernen des Weichstempels kann beispielsweise durch eines der folgenden Verfahren und/oder durch eine Kombination solcher Verfahren erfolgen: thermisch z.B. durch Temperaturerhöhung oberhalb der Glasübergangstemperatur, mechanisch, physikalisch und/oder chemischphysikalisch z.B. durch Veraschung mit Plasma, insbesondere mit $O_2$-Plasma, chemisch z.B. durch chemische Reinigung mit Lösungsmittel wie Piranha bzw. Lösungsmittelmischungen. Die vollständige Ablösung kann insbesondere durch die Kombination von chemischen Lösen oder thermische Behandlung und mechanischer Einwirkung erfolgen.

In einer anderen bevorzugten Ausführungsform können alle möglichen und denkbaren Halbleiterbauteile direkt im Träger gefertigt werden. Denkbar ist beispielsweise, dass neben den erfindungsgemäßen Heizelementen direkt Mikrochips für die Messung, Temperatursensoren, Biegesensoren etc. in den Träger eingebaut werden, um den Träger mit mehreren unterschiedlichen aktiven und passiven Bauteilen zu versehen. Der Träger wird dadurch vom reinen Konstruktionselement zum Funktionselement.

Verfahren

Die Erfindung betrifft weiterhin ein Verfahren zum Prägen einer Prägemasse mit dem erfindungsgemäßen Stempel sowie die Verwendung des erfindungsgemäßen Stempels zum Prägen einer Prägemasse.

In einem ersten erfindungsgemäßen Verfahrensschritt wird ein Substrat mit einer Prägemasse beschichtet. Das Substrat befindet sich dabei auf einem Substrathalter und wird vorzugsweise vom Substrathalter fixiert, sodass eine Verschiebung des Substrats nicht mehr möglich ist.

In einem zweiten erfindungsgemäßen Verfahrensschritt wird der Stempel relativ zum Substrat, insbesondere mit optischen Hilfsmitteln, ausgerichtet. Die Ausrichtung erfolgt vorzugsweise mit Hilfe von Ausrichtungsmarken die sich einerseits am Träger, noch bevorzugter am Weichstempel, andererseits am Substrat befinden. Dadurch wird eine sehr genaue Positionierung des Weichstempels ermöglich. Sind Träger und Weichstempel und/oder Substrat und Substrathalter insbesondere transparent für die zur Ausrichtung verwendete elektromagnetische Strahlung, erfolgt die Ausrichtung der beiden Objekte vorzugsweise durch eine sogenannte face-to-face Ausrichtung.

In einem dritten erfindungsgemäßen Verfahrensschritt erfolgt eine Prägung der Prägemasse durch den Stempel, insbesondere durch den Weichstempel. Die Prägung kann dabei entweder so erfolgen, dass der Weichstempel durch eine relative Annäherung von Substrat und Träger zueinander die Prägemasse kontaktiert und möglichst gleichmäßig prägt. Denkbar ist auch, dass ein Verformelement verwendet wird, um den Stempel, insbesondere zentrisch, konvex zu krümmen und dadurch mit seinem zentrischen Teil zuerst in die Prägemasse zu drücken.

Der Träger kann während der Verformung mit dem Trägerhalter, insbesondere peripher, verbunden bleiben oder vollständig vom Trägerhalter gelöst werden. Insbesondere wird hier auf die Druckschrift WO2015161868 verwiesen. Denkbar ist auch, dass Stempel und Prägemasse relativ zueinander angenähert werden, ohne dass der Stempel verformt wird.

In einem vierten erfindungsgemäßen Verfahrensschritt erfolgt eine Erwärmung der Prägemasse durch die erfindungsgemäße Ausführungsform. Erfindungsgemäß wird dabei die Wärme in den Heizelementen des Trägers, d.h. möglichst nahe an der Prägemasse erzeugt.

In einem fünften erfindungsgemäßen Verfahrensschritt erfolgt eine Entformung des Stempels, insbesondere des Weichstempels, von der Prägemasse.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:

Figur 1a    eine erste erfindungsgemäße Ausführungsform in Seitenansicht,

Figur 1b    die erste erfindungsgemäße Ausführungsform in Draufsicht,

Figur 2a    eine zweite erfindungsgemäße Ausführungsform in Seitenansicht,

Figur 2b    die zweite erfindungsgemäße Ausführungsform in Draufsicht,

Figur 3a    eine dritte erfindungsgemäße Ausführungsform in Seitenansicht,

Figur 3b    die dritte erfindungsgemäße Ausführungsform in Draufsicht,

Figur 4     eine erfindungsgemäße Vorrichtung.

In den Figuren sind gleiche Bauteile oder Bauteile mit der gleichen Funktion mit den gleichen Bezugszeichen gekennzeichnet.

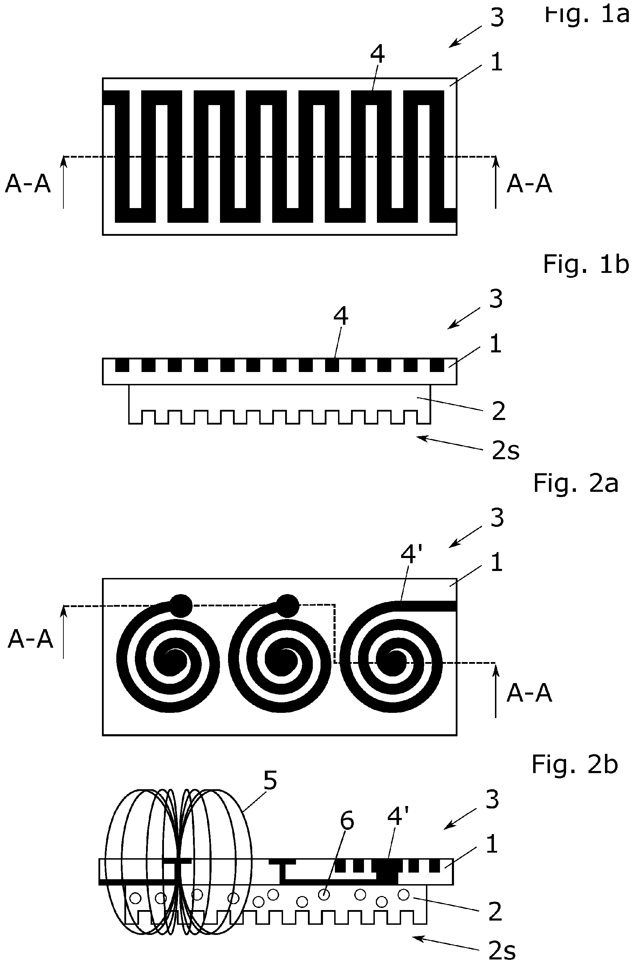

Die Figur 1a zeigt eine Oberansicht einer ersten erfindungsgemäßen Ausführungsform eines Stempels 3, bestehend aus einem Träger 1 und einem Weichstempel 2 (in der Oberansicht nicht sichtbar). Der Träger 1 verfügt erfindungsgemäß über Heizelemente 4. Die Heizelemente 4 sind in der Figur 1a als einfache, mäanderförmige Leiterbahnen dargestellt. Die Leiterbahnen werden von einem Strom durchflossen. Die hohe Stromdichte erzeugt genug Joulesche Wärme, um damit den erfindungsgemäßen Heizvorgang durchzuführen. Handelt es sich beim Träger 1 um ein Dielektrikum, werden die Heizelementen 4 vorzugsweise aus einem Metall hergestellt. Handelt es sich bei dem Träger 1 um ein Halbleitermaterial, können die Heizelemente 4 beispielsweise dotierte, insbesondere n-dotierte, Bereiche sein.

Die Figur 1b zeigt eine Seitenansicht der ersten erfindungsgemäßen Ausführungsform eines Stempels 3, bestehend aus einem Träger 1 und einem Weichstempel 2. Die Teile des Stempels 3 sind nicht maßstabsgetreu dargestellt, um die Darstellung zu verbessern. Insbesondere sind die Weichstempelstrukturen 2s um ein Vielfaches kleiner in Bezug zur gesamten Größe des Weichstempels 2.

Die Figur 2a zeigt eine Oberansicht einer zweiten erfindungsgemäßen Ausführungsform eines Stempels 3, bestehend aus einem Träger 1 und einem Weichstempel 2. Der Träger 1 verfügt erfindungsgemäß über Heizelemente 4' in Spulenform. Die Leiterbahnen werden von einem Strom durchflossen. Die hohe Stromdichte erzeugt genug Joulesche Wärme, um damit den erfindungsgemäßen Heizvorgang durchzuführen. Erfindungsgemäß bevorzugt ist allerdings, dass die spulenförmigen Heizelemente 4' von einem hochfrequenten Wechselstrom durchflossen werden, um eine starke zeitliche Änderung des magnetischen Flusses zu erzeugen.

Die Figur 2b zeigt eine Seitenansicht der zweiten erfindungsgemäßen Ausführungsform eines Stempels 3, bestehend aus einem Träger 1 und einem Weichstempel 2. Die magnetischen Feldlinien 5 werden exemplarisch für eines der spulenförmigen Heizelemente 4' dargestellt. Auf die Darstellung der magnetischen Feldlinien 5 für die beiden anderen Heizelemente 4' wird der Übersichtlichkeit halber verzichtet.

Ein sich zeitlich änderndes magnetische Feld induziert in einem von den magnetischen Feldlinien 5 durchströmten Elektrikum eine Spannung und erzeugt damit im Elektrikum einen Strom. Dieser Strom erzeugt wiederum Joulesche Wärme. Insbesondere wird durch den sogenannten Skin-Effekt dafür gesorgt, dass sich die so induzierten Ströme nur an der Oberfläche des Elektrikums befinden und das Elektrikum entsprechend stark aufheizen.

Denkbar ist das Aufheizen von, insbesondere, metallischen, Partikeln 6, die sich im Weichstempel 2 befinden. Vorteilhaft wird damit die Erwärmung noch näher an den Weichstempel 2, und damit an die Prägemasse herangebracht. Die Heizelemente 4' sind direkt im Träger 1 eingebaut und verformen sich mit dem Träger mit und passen sich an.

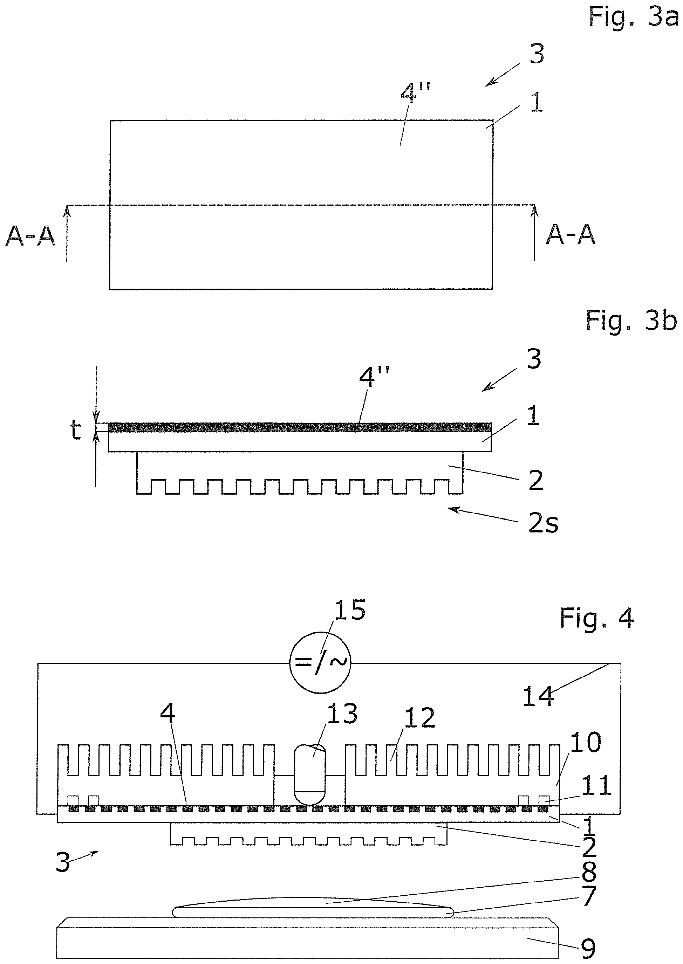

Die Figur 3a zeigt eine Oberansicht einer dritten erfindungsgemäßen Ausführungsform eines Stempels 3, bestehend aus einem Träger 1 und einem Weichstempel 2. In dieser speziellen Ausführungsform ist der gesamte Träger 1 leitfähig und wird vollflächig von einem Strom durchflossen. Das (insbesondere einzige) Heizelement 4" kann wiederum ein Metall oder ein dotierter Halbleiter sein.

Die Figur 3b zeigt eine Seitenansicht der dritten erfindungsgemäßen Ausführungsform eines Stempels 3, bestehend aus einem Träger 1 und einem Weichstempel 2. Das Heizelement 4" erstreckt sich nur über eine, insbesondere geringe, Dicke t. Durch die geringe Dicke t wird sichergestellt, dass die Stromdichte und damit die Joulesche Wärme möglichst hoch sind.

Die Figur 4 zeigt eine Seitenansicht einer Vorrichtung, aufweisend den Stempel 3, mit Träger 1 und Weichstempel 2, eine Trägerhalter 10, mit Fixierungen 11, welche den Träger 1 am Trägerhalter 10 fixieren, einem Verformelement 13 zur Verformung des Stempels 3, Kühlelemente 12 zur Kühlung des Trägerhalters 10 und damit auch des Stempels 3, sowie einem Substrathalter 9, welcher das Substrat 7, auf dem die Prägemasse 8 abgeschieden wird, aufnimmt. Die Stromquelle 15 kann, abhängig von der jeweils verwendeten erfindungsgemäßen Ausführungsform, entweder eine Gleichstrom- oder eine Wechselstromquelle sein. Über den Stromkreis 14, werden die Heizelemente 4 im Träger 1 mit Strom versorgt.

Der erfindungsgemäße Gedanke des Einbaus von Heizelementen 4 in den Träger 1 wird um die optionale Möglichkeit einer aktiven und/oder passiven Kühlung des Stempels 3 durch den Trägerhalter 10 erweitert. Insbesondere durch die Verwendung einer aktiven Kühlung mittels Kühlelementen 12, vorzugsweise Kühlrippen, die von einem Fluid umströmt werden, kann der Träger 1 wieder sehr rasch gekühlt werden.

## Bezugszeichenliste

| | |
|---|---|
| 1 | Träger |
| 2 | Weichstempel |
| 2s | Weichstempelstrukturen |
| 3 | Stempel |
| 4, 4',4" | Heizelemente |
| 5 | Magnetische Feldlinien |
| 6 | Partikel, insbesondere Nanopartikel |
| 7 | Substrat |
| 8 | Prägemasse |
| 9 | Substrathalter |
| 10 | Trägerhalter |
| 11 | Fixierung |
| 12 | Kühlelement |
| 13 | Krümmungselement |
| 14 | Stromkreis |
| 15 | Stromquelle |
| t | Dicke der Heizelemente |

## Patentansprüche

1. Stempel (3), aufweisend einen Weichstempel (2) und einen am Weichstempel (2) fixierten biegbaren Träger (1), wobei der Träger (1) mindestens ein Heizelement (4, 4' 4") aufweist und lösbar am Weichstempel (2) fixiert ist.

2. Stempel (3) nach Anspruch 1, wobei der Stempel (3) einen temperierbaren Trägerhalter (10) aufweist.

**3.** Stempel (3) gemäß einen der vorhergehenden Patentansprüche, wobei das mindestens eine Heizelement (4) als, insbesondere mäanderförmige, Leiterbahn ausgebildet ist, insbesondere als metallischer und/oder n-dotierter Bereich.

**4.** Stempel (3) gemäß einem der vorhergehenden Patentansprüche, wobei das mindestens eine Heizelement (4') als Spule, insbesondere Flachspule, ausgebildet ist.

**5.** Stempel (3) gemäß einem der vorhergehenden Patentansprüche, wobei der Weichstempel (2) leitfähige Nanopartikel (6) aufweist.

**6.** Stempel (3) gemäß einem der vorhergehenden Patentansprüche, wobei das mindestens eine Heizelement (4") als leitfähige Schicht im und/oder auf dem Träger (1) ausgebildet ist, bevorzugt besteht der Träger (1) zumindest teilweise, vorzugsweise vollständig, aus einem leitfähigen Material, insbesondere Metall.

**7.** Stempel (3) gemäß einem der vorhergehenden Patentansprüche, wobei im Träger (1) eine Stromdichte zwischen 0.01 A/m$^2$ und 1 MA/m$^2$ erzeugbar ist, vorzugsweise zwischen 0.1 A/m$^2$ und 1 MA/m$^2$, bevorzugter zwischen 1 A/m$^2$ und 1 MA/m$^2$, noch bevorzugter zwischen 10 A/m$^2$ und 1 MA/m$^2$, am bevorzugtesten zwischen 100 A/m$^2$ und 1 MA/m$^2$, am allerbevorzugtesten zwischen 1000 A/m$^2$ und 1 MA/m$^2$.

**8.** Stempel (3) gemäß einem der vorhergehenden Patentansprüche, wobei der Träger (1) als Platte ausgebildet ist, wobei die Dicke der Platte zwischen 0.01 mm und 20 mm beträgt, vorzugsweise zwischen 0.05 mm und 15 mm, bevorzugter zwischen 0.1 mm und 10 mm, noch bevorzugter zwischen 0.5 mm und 5 mm, am bevorzugtesten zwischen 0.75mm und 2.5 mm, am allerbevorzugtesten zwischen 1 mm und 2 mm.

**9.** Stempel (3) gemäß einem der vorhergehenden Patentansprüche, wobei der Träger (1) als Folie ausgebildet ist, insbesondere als Folie bestehend aus einem organischen Halbleiter, wobei die Dicke der Folie zwischen 0.01 mm und 5 mm beträgt, vorzugsweise zwischen 0.05 mm und 2.5 mm, bevorzugter zwischen 0.1 mm und 2 mm, noch bevorzugter zwischen 0.5 mm und 1.5 mm, am bevorzugtesten zwischen 0.7 5mm und 1.25 mm, am allerbevorzugtesten zwischen 1 mm und 1.25 mm.

**10.** Vorrichtung, aufweisend einen Stempel (3) gemäß einem der vorhergehenden Patentansprüche, sowie eine Steuerungseinheit (15), insbesondere eine Strom- und/oder Spannungsquelle, zur Steuerung des mindestens einen Heizelements (4,4',4").

**11.** Verwendung eines Stempels (3) gemäß einem der vorhergehenden Patentansprüche 1 bis 9 zum Prägen einer Prägemasse.

**12.** Verfahren zum Prägen einer Prägemasse (8) mit einem Stempel (3) gemäß einem der vorhergehenden Ansprüche 1 bis 9, mit den folgenden Schritten, insbesondere dem folgenden Ablauf:

- Beschichten eines Substrats (7) mit der Prägemasse (8),
- Ausrichten des Stempels (3) relativ zum Substrat (7),
- Prägen der Prägemasse (8) durch den Stempel (3),
- Erwärmung der Prägemasse (8) durch das mindestens eine Heizelement (4,4',4") des Trägers (1),
- Entformung des Stempels (3) von der Prägemasse (8).

**Claims**

**1.** A stamp (3) comprising a soft stamp (2) and a flexible carrier (1) fixed on the soft stamp (2), wherein the carrier (1) comprises at least one heating element (4, 4', 4") and is fixed detachably to the soft stamp (2).

**2.** The stamp (3) according to claim 1, wherein the stamp (3) comprises a temperature-controlled carrier holder (10).

**3.** The stamp (3) according to any one of the preceding claims, wherein the at least one heating element (4) is constituted as an, in particular meandering, strip conductor, in particular as a metallic and/or n-doped region.

**4.** The stamp (3) according to any one of the preceding claims, wherein the at least one heating element (4') is constituted as a coil, in particular a flat coil.

**5.** The stamp (3) according to any one of the preceding claims, wherein the soft stamp (2) comprises conductive nanoparticles (6).

**6.** The stamp (3) according to any one of the preceding claims, wherein the at least one heating element (4") is constituted as a conductive layer in and/or on the carrier (1), the carrier (1) preferably consisting at least partially, preferably completely, of a conductive material, in particular metal.

**7.** The stamp (3) according to any one of the preceding claims, wherein there can be generated in the carrier (1) a current density between 0.01 A/m$^2$ and 1 MA/m$^2$, preferably between 0.1 A/m$^2$ and 1 MA/m$^2$, more preferably between 1 A/m$^2$ and 1 MA/m$^2$, still more preferably between 10 A/m$^2$ and 1 MA/m$^2$, most preferably between 100 A/m$^2$ and 1 MA/m$^2$, with utmost preference between 1000 A/m$^2$ and 1 MA/m$^2$.

8. The stamp (3) according to any one of the preceding claims, wherein the carrier (1) is constituted as a plate, wherein the thickness of the plate amounts to between 0.01 mm and 20 mm, preferably between 0.05 mm
and 15 mm, more preferably between 0.1 mm and 10 mm, still more preferably between 0.5 mm and 5 mm, most preferably between 0.75 mm and 2.5 mm, with utmost preference between 1 mm and 2 mm.

9. The stamp (3) according to any one of the preceding claims, wherein the carrier (1) is constituted as a film, in particular as a film comprising an organic semiconductor, wherein the thickness of the film amounts to between 0.01 mm and 5 mm, preferably between 0.05 mm and 2.5 mm, more preferably between 0.1 mm and 2 mm, still more preferably between 0.5 mm and 1.5 mm, most preferably between 0.75 mm and 1.25 mm, with utmost preference between 1 mm and 1.25 mm.

10. A device, comprising a stamp (3) according to any one of the preceding claims, as well as a control unit (15), in particular a current and/or voltage source, for controlling the at least one heating element (4, 4', 4").

11. Use of a stamp (3) according to any one of the preceding claims 1 to 9 for embossing an embossing compound.

12. A method for embossing an embossing compound (8) with a stamp (3) according to any one of the preceding claims 1 to 9, with the following steps, in particular the following sequence:

    - coating of a substrate (7) with the embossing compound (8),
    - alignment of the stamp (3) relative to the substrate (7),
    - embossing of the embossing compound (8) by means of the stamp (3),
    - heating of the embossing compound (8) by means of the at least one heating element (4, 4', 4") of the carrier (1),
    - removal of the stamp (3) from the embossing compound (8).

**Revendications**

1. Poinçon (3), présentant un poinçon souple (2) et un support (1) flexible fixé sur le poinçon souple (2), dans lequel le support (1) présente au moins un élément chauffant (4, 4', 4") et est fixé de manière séparable sur le poinçon souple (2).

2. Poinçon (3) selon la revendication 1, dans lequel le poinçon (3) présente un porte-support (10) pouvant être mis en température.

3. Poinçon (3) selon l'une des revendications précédentes, dans lequel l'au moins un élément chauffant (4) est formé en tant qu'une piste conductrice, en particulier sinueuse, en particulier en tant qu'une zone métallique et/ou dopée n.

4. Poinçon (3) selon l'une des revendications précédentes, dans lequel l'au moins un élément chauffant (4') est formé en tant qu'une bobine, en particulier une bobine plate.

5. Poinçon (3) selon l'une des revendications précédentes, dans lequel le poinçon souple (2) présente des nanoparticules (6) conductrices.

6. Poinçon (3) selon l'une des revendications précédentes, dans lequel l'au moins un élément chauffant (4") est conçu en tant que couche conductrice dans et/ou sur le support (1), de préférence, le support (1) est composé au moins partiellement, de préférence entièrement, d'un matériau conducteur, en particulier du métal.

7. Poinçon (3) selon l'une des revendications précédentes, dans lequel une densité de courant entre 0,01 A/m$^2$ et 1 MA/m$^2$ peut être produite dans le support (1), de préférence entre 0,1 A/m$^2$ et 1 MA/m$^2$, de manière plus préférée entre 1 A/m$^2$ et 1 MA/m$^2$, de manière encore plus préférée entre 10 A/m$^2$ et 1 MA/m$^2$, de manière la plus préférée entre 100 A/m$^2$ et 1 MA/m$^2$, de manière préférée entre toutes entre 1000 A/m$^2$ et 1 MA/m$^2$.

8. Poinçon (3) selon l'une des revendications précédentes, dans lequel le support (1) est conçu en tant que plaque, dans lequel l'épaisseur de la plaque fait entre 0,01 mm et 20 mm, de préférence entre 0,05 mm et 15 mm, de manière plus préférée entre 0,1 mm et 10 mm, de manière encore plus préférée entre 0,5 mm et 5 mm, de manière la plus préférée entre 0,75 mm et 2,5 mm, de manière préférée entre toutes entre 1 mm et 2 mm.

9. Poinçon (3) selon l'une des revendications précédentes, dans lequel le support (1) est conçu en tant que film, en particulier en tant que film composé d'un semi-conducteur organique, dans lequel l'épaisseur du film fait entre 0,01 mm et 5 mm, de préférence entre 0,05 mm et 2,5 mm, de manière plus préférée entre 0,1 mm et 2 mm, de manière encore plus préférée entre 0,5 mm 1,5 mm, de manière la plus préférée entre 0,75 mm et 1,25 mm, de manière préférée entre toutes entre 1 mm et 1,25 mm.

**10.** Dispositif, présentant un poinçon (3) selon l'une des revendications précédentes, ainsi qu'une unité de commande (15), en particulier une source de courant et/ou de tension, pour commander l'au moins un élément chauffant (4, 4', 4").

**11.** Emploi d'un poinçon (3) selon l'une des revendications 1 à 9 pour matricer une masse à matricer.

**12.** Procédé de matriçage d'une masse à matricer (8) avec un poinçon (3) selon l'une des revendications précédentes 1 à 9, comprenant les étapes suivantes, en particulier le déroulement suivant :

> - revêtement d'un substrat (7) avec la masse à matricer (8),
> - alignement du poinçon (3) par rapport au substrat (7),
> - matriçage de la masse à matricer (8) par le poinçon (3) ;
> - chauffage de la masse à matricer (8) par l'au moins un élément chauffant (4, 4', 4") du support (1),
> - démoulage du poinçon (3) de la masse à matricer (8).

Fig. 1a

3

4

1

A-A

A-A

Fig. 1b

3

4

1

2

2s

Fig. 2a

3

4'

1

A-A

A-A

Fig. 2b

3

5

6

4'

1

2

2s

Fig. 3a

Fig. 3b

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017176853 A1
- EP 2942667 A2
- CN 102275445 A
- US 2003234470 A1
- US 2004036201 A1
- WO 2015078520 A1
- WO 2015161868 A